Europäisches Patentamt

**European Patent Office**

Office européen des brevets

(19)

(11) Numéro de publication: **0 074 303**
**B1**

(12) **FASCICULE DE BREVET EUROPEEN**

(45) Date de publication du fascicule du brevet:
26.02.86

(21) Numéro de dépôt: **82401565.5**

(22) Date de dépôt: **23.08.82**

(51) Int. Cl.⁴: **H 05 K 1/00, H 05 K 3/46**

(54) Ebauche de circuit électrique multicouche et procédé de fabrication de circuits multicouches en comportant application.

(30) Priorité: **02.09.81 FR 8116718**

(43) Date de publication de la demande:
**16.03.83 Bulletin 83/11**

(45) Mention de la délivrance du brevet:
**26.02.86 Bulletin 86/9**

(84) Etats contractants désignés:
**CH DE FR GB IT LI NL**

(56) Documents cités:
**DE - A - 2 929 050**
**DE - A - 2 929 051**
**GB - A - 2 045 538**

(73) Titulaire: **Rouge, François, 27, rue Audran, F-94400 Vitry S/Seine (FR)**

(72) Inventeur: **Rouge, François, 27, rue Audran, F-94400 Vitry S/Seine (FR)**

(74) Mandataire: **Fort, Jacques et al, CABINET PLASSERAUD 84, rue d'Amsterdam, F-75009 Paris (FR)**

LIBER, STOCKHOLM 1986

## Description

La présente invention a pour objet la réalisation de circuits électriques multicouches et elle trouve une application particulièrement importante, bien que non exclusive, constituée par la réalisation de cartes imprimées multicouches destinées à recevoir des boîtiers logiques.

La plupart des ébauches de cartes imprimées multicouches disponibles à l'heure actuelle sont réalisées, par pressage en masse, avec des couches internes, destinées à constituer les plans de masse et d'alimentation électrique, gravées d'avance suivant un tracé défini par le client. Les liaisons logiques s'effectuent sur les couches externes et les connexions entre une face et l'autre face (ou une couche interne) par des trous métallises. Cette solution présente le grave inconvenient qu'il est nécessaire de définir un tracé de couche interne pour chaque besoin particulier, d'où un coût éleve puisqu'un travail de conception est à refaire pour chaque circuit, que les quantités sont faibles et que les ébauches en excés ne sont pas utilisables pour d'autres réalisations.

On connaît également des cartes multicouches dont les couches internes sont prédéfinies suivant des tracés types. Mais ces cartes ont également de nombreux inconvénients. En particulier, elles imposent des contraintes d'implantation des composants, ce qui limite leur domaine d'emploi et réduit la densité d'implantàtion de composants extérieurs qu'il est possible d'atteindre.

On connaît notamment (DE-A-2929050) une ébauche suivant le préambule des revendications 1 et 2. Mais le réseau conducteur décrit par ce document a un motif à deux axes de symêtrie. En conséquence les trous métallisés de liaison entre faces opposées ne peuvent être perçes que dans des zones qui ne constituent pas des noeuds du réeau conducteur et on doit donner soit aux trous, soit au réseau conducteur une faible section.

En résumé,les ébauches existantes ne constituent pas des composants standard utilisables pour réaliser ultérieurement tout type de circuit. Il n'est pas possible de traiter ces ébauches comme une carte double face à trous métallisés classique, puisque des contraintes sur les emplacements de perçage des trous de liaison entre les faces doivent être respectées. Il n'est pas possible de stocker les couches internes sous forme de cartes prépressés. Enfin, lorsque les couches d'alimentation et de masse sont predefinies, la densite d'implantation est réduite et, en particulier, on ne peut implanter les composants à tous les npeuds de la grille standard à pas de 2,54 mm (un dixième de pouce).

La présente invention vise notamment à fournir une ébauche en vue de la réalisation d'un circuit électrique multicouches répondant mieux que celles antérieurement connues aux exigences de la pratique, en particulier en ce que le coût d'etude est réduit du fait de l'emploi d'une ébauche standard, en ce que les coûts de production de l'ébauche sont réduits grâce à la fabrication à grande échelle, en ce que des densités d'intégration importantes peuvent être obtenues du fait qu'il est possible d'implanter les composants à tous les noeuds de la grille standard et en ce qu'aucune contrainte n'est à respecter en ce qui concerne l'emplacement des trous métallisés.

Dans ce but, l'invention propose notamment une ébauche telle que définies par les revendications 1 et 2.

Une telle ébauche peut être realisée en série de façon classique par pressage ou laminage. Du fait du caractère continu du réseau conducteur, il présente une impédance qui est sensiblement la même quel que soit l'emplacement du site.

En general, 1'ébauche comportera deux couches internes parallèles, dont l'une constituera liaison de masse et l'autre liaison d'alimentation ; leurs grilles seront decalées de $p$ suivant une des dimensions du réseau. Ainsi, on peut aisément effectuer, à l'aide de trous métallisés, une liaison entre les deux faces de l'ébauche en l'un quelconque des noeuds du premier réseau et une liaison avec l'alimentation ou la masse à l'aide d'un trou métal-lisé en un noeud de la seconde grille.

L'invention propose également un procédé de fabrication de circuits électriques multicouches double face à partir d'une ébauche du genre ci-dessus défini. On effectue les connexions entre faces à l'aide de trous metallisés qui peuvent être percés en l'un quelconque des sites de la première grille. Si les autres sites comportent des zones conductrices qui sont annulaires et non pas pleines, on peut également effectuer une connexion entre faces à l'aide d'un trou metéllise de diamètre inférieur é celui du cercle inscrit dans la zone. Les liaisons entre une face et la couche interne peuvent être réalisées à l'aide d'un trou métallisé percé en l'un desdits autres sites. Lorsque deux couches internes sont prevues, cette liaison avec l'une des couches sera réalisée en perçant un trou métallisé en un desdits autres sites d'une des couches qui se trouve face à celui des sites de la seconde couche qui est non conducteur.

L'invention sera mieux comprise à la lecture de la description qui suit d'un mode particulier de réalisation, donné à titre d'exemple non limitatif. La description se réfère aux dessins qui l'accompagnent, dans lesquels :.

- la figure 1 est une vue en plan montrant un fragment du réseau conducteur d'une couche interne d'ébauche suivant un mode particulier de réalisation de l'invention,

- la figure 2 est un schéma qui montre,en perspec tive écfatée, un fragment des faces et des couches internes d'une ébauche de carte imprimée utilisant des motifs du genre montré en Figure 1,ainsi qu'un exemple de liaisont,

- les figures 3 et 4, similaires aux figures 1 et 2, montrent une variante de réelisation adaptée à la constitution des cartes logiques sur lesquelles des jonctions équipotentielles sont réalisées à l'aide de fils soudés et collés.

L'invention sera maintenant décrite en la supposant appliquée à la constitution d'ébauches de cartes imprimées multicouches destinées à constituer des cartes logiques. De façon classique,cette ébauche se présente sous forme d'un support plat en matériau isolant portant, sur ses deux faces termineles, des coucnes ou des pistes minces en matériau conducteur. Deux couches conductrices parallèles aux faces sont ménagées dans l'épaisseur du support.

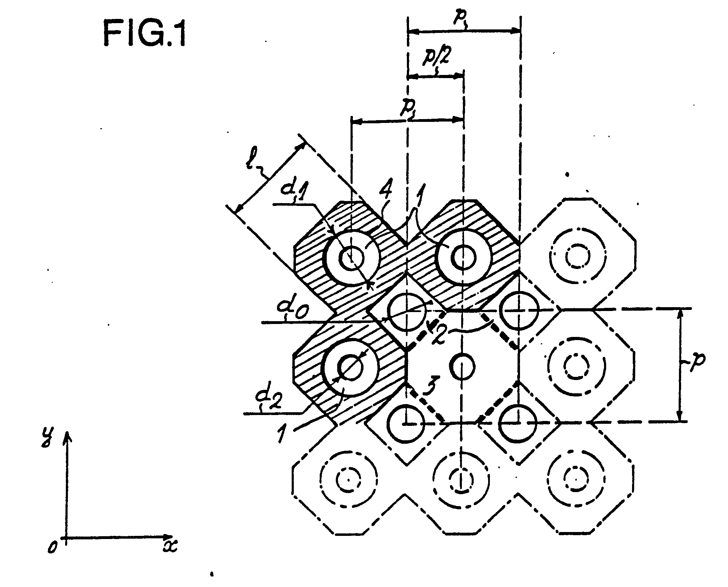

Chacune des couches internes porte un réseau conducteur continu, formé par une couche métallique mince. Ce réseau est constitué par la répétition, suivant deux dimensions, d'un motif élémentaire indiqué en traits pleins sur la Figure 1. Ce motif,constitué par une coucne métallique mince, se présente sous forme de carrés juxtaposés centrés sur les noeuds d'un réseau régulier de pas $p$,suivant deux directions OX et OY. En général, le pas $p$ sera le pas d'implantati on normal de 2,54 mm utilisé pour l'implantation des boîtiers de circuits logiques sur une carte. La longueur $l$ des côtés des carrés est telle que leurs angles se recouvrent de manière à assurer une continuité électrique. Dans le cas d'un pas $p$ de 2,54 mm, la distance entre côtés opposés sera par exemple de 2,2 mm.

La juxtaposition suivant les directions Ox et Oy du motif ainsi constitué permet de définir une première grille de pas constant $p$ décalée de p/2 par rapport aux noeuds du réseau conducteur. La zone située autour de chacun des noeuds de cette première grille constitue des sites non conducteurs 2. Un trou métallisé percé au travers de la plaque en l'un quelconque des sites 2 ne rencontre aucune zone conductrice de la couche et permet d'établir une jonction entre les faces opposées, à condition d'avoir un diamètre suffisamment faible. Dans la pratique, pour tenir compte des tolérances de fabrication et des erreurs de centrage lors du perçage, on peut considérer que les trous métallisés percés aux sites 2 ne devront pas dépasser un diamètre $d_0$ de 0,8 mm dans le cas d'un pas $p$ de 2,54 mm.

Chacun des motifs montrés en figure 1 définit de son côté quatre sites supplémentaires, décalés dans les deux directions Ox et OY de p/2 par rapport aux sites 2. Trois des sites, désignés par la référence 1, sont au centre de carrés conducteurs. Le quatrième, désigné par 3, occupe un emplacement où n'existe pas de carré conducteur dans le motif. Un trou métallisé percé au site 3 ne rencontrera pas les zones conductrices du réseau, à condition d'être de diamètre suffisamment faible.

Dans le mode de réalisation montré en Figure 1, la partie conductrice dans chaque carré se limite à une zone annulaire dont le périmètre externe est constitué par le carré et dont le périmètre interne est constitué par un cercle 4 de diamètre d . Dans ces conditions, un trou métallisé percé à travers la plaque en l'un quelconque des sites 1 ne rencontrera pas la zone conductrice si son diamètre $d_2$ est suffisamment faible. Dans la pratique, dans le cas d'un pas p de 2,54 mm, on pourra choisir des valeurs de 1,4 mm et 0,5 mm pour $d_1$ et la valeur maximum de $d_2$ respectivement.

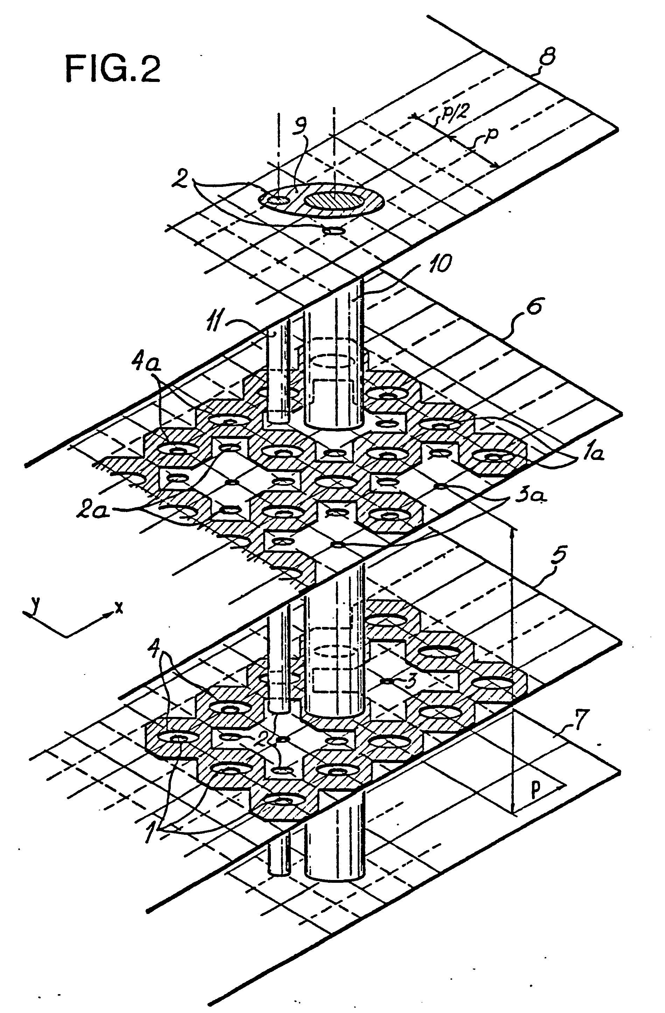

La Figure 2 montre le cas le plus fréquent où l'ébauche comprend deux couches internes 5 et 6, constituant respectivement plan commun de masse et plan commun d'alimentation à tension Vcc, parallèles aux faces terminales 7 et 8. Dans ce cas, chacune des couches a la constitution montrée en Figure 1, mais les motifs de l'une sont décalés par rapport aux motifs de l'autre de p dans l'une des directions, que l'on supposera être Ox. Pour plus de simplicité, les référence utilisées sur la Figure 1 ont été reportées sur la Figure 2, affectées de l'indice $\underline{a}$ lorsqu'elles concernent la couche 6.

La réalisation d'interconnexions s'effectue alors de la façon suivante.

- Pour interconnecter des plages situées sur les faces externes opposées du circuit, il suffit de percer un trou dont le diamètre est suffisamment faible pour qu'il n'entame pas une zone conductrice en l'un quelconque des sites 1, 2 et 3 et de métalliser ce trou.

- Une liaison entre les faces terminales et le plan de masse s'effectuera en perçant un trou de diamètre suffisamment élevé (typiquement 1,8 mm dans le cas d'un pas de 2,54 mm) en l'un quelconque des sites $3\underline{a}$ du réseau conducteur de la couche 6 et en le métallisant. La paroi de ce trou ne sera pas en contact avec une zone conductrice du réseau conducteur de la couche 6. Par contre elle sera en contact avec la zone annulaire conductrice autour d'un des sites 1 du réseau de la couche 5. Pour effectuer une jonction entre un composant fixé sur la face 8, en un site 2 du réseau d'implantation et Ie plan de masse, il suffit de créer une piste conductrice 9 vers la zone entourant le débouché du trou métallisé 10 de jonction avec le plan de masse. Cette piste peut être reliée à la face 7 par un trou métallisé 11 qui, à condition de n'avoir pas un diamètre supérieur à $d_0$, n'entrera en contact ni avec le plan de masse, ni avec le plan d'alimentation.

- La jonction entre l'une des faces 7 et 8 et le plan d'alimentation s'effectue, comme dans le cas précédent, si ce n'est que les trous métallisés de diamètre suffisant sont percés en l'un des sites 3 du réseau de la couche 5.

L'invention ne se limite nullement au mode particulier de réalisation représenté et décrit à titre d'exemple. Les motifs peuvent avoir des formes,três différentes de celles qui ont été représentées. L'ébauche peut être destinée à la constitution de circuits comportant, sur les faces terminales, non pas des pistes imprimées, mais des connexions en fils isolés soudés a leurs extrémités et pouvant être collés sur les faces terminales en partie courante.

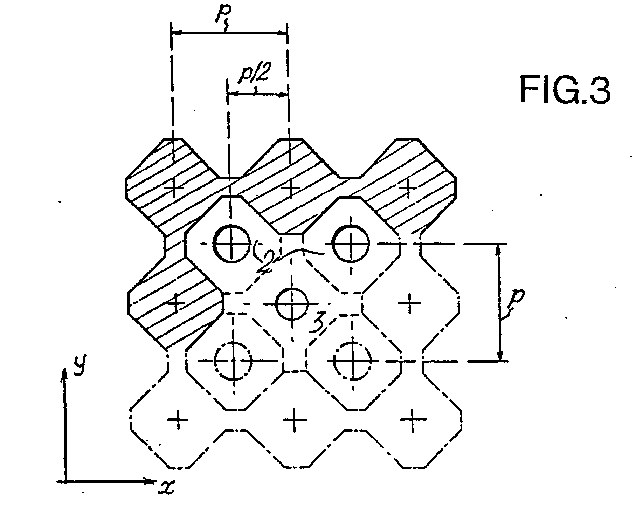

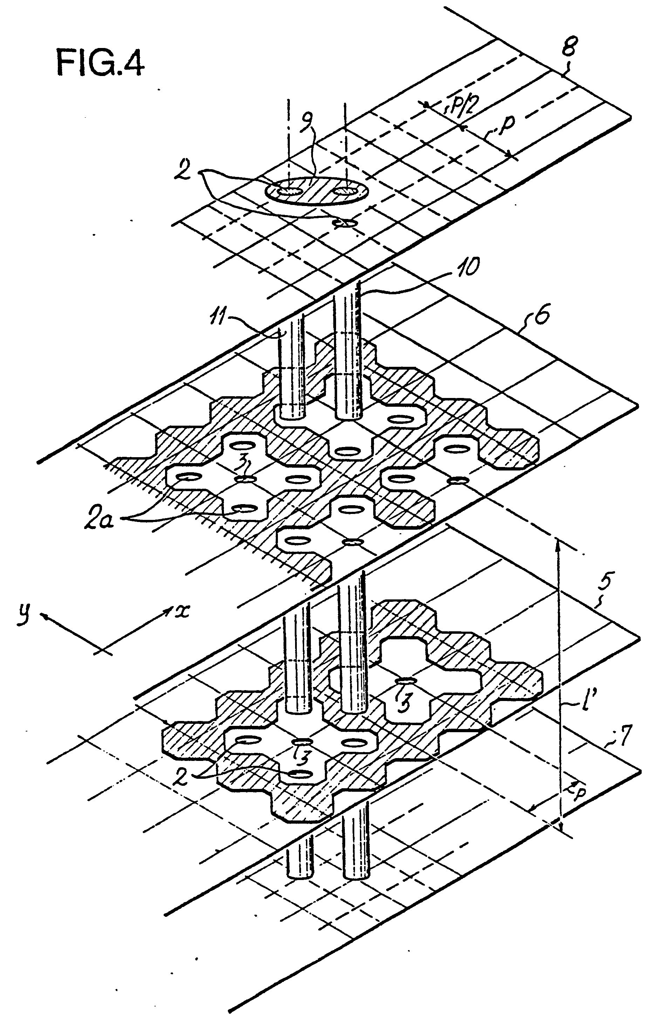

Les figures 3 et 4 montrent une ébauche suivant une première variante de réalisation, destinée à la constitution de circuits par réalisation des liaisons équipotentielles requises à l'aide de fils isolés soudés. Dans cette variante, le motif élémentaire (figure 3) présente la même allure générale que celui de la figure 1, mais

- les sites 1 appartenant au réesau conducteur sont pleins, les trous de traversée 4 prévus sur les figures 1 et 2 n'étant pas nécessaires;

- de ce fait, il est possible d'adopter un réseau conducteur dont les zones conductrices individuelles ont une dimension en plan plus faible.

On peut par exemple adopter, pour un pas p de 2,54 mm, une largeur l' de 1,4 mm, ce qui permet de donner aux trous métallisés de liaison 10 aux sites 3 entre les faces terminales et un des plans communs, un diamètre allant jusqu'à 1 mm avec les tolérances de centrage habituelles. Le diamètre des trous 11 de liaison entre les faces, destinés aux pattes de composants, percés en des sites 2, pourra pratiquement aller jusqu'à 1,2 mm. Les faces terminales 7 et 8 seront constituées par des couches spécifiques du type de connexion équipotentielle choisi, qui peut par exemple être celui connu sous la marque "MULTIWIRE". Les couches internes 5 et 6 sont encore décalées l'une de l'autre de p dans la direction x.

**Revendications**

1. Ebauche pour circuit électrique multicouche comprenant un support plat en matériau isolant qui contient au moins une couche interne (5,6) parallèle aux faces du support et présentant un réseau conducteur continu formé par la répétition à deux dimensions d'un même motif caractérisée en ce que la répétition s'effectue, par translation de pas (2p) suivant deux directions orthogonales, d'un motif constitué de quatre carrés dont les diagonales sont parallèles aux dites directions orthogonales et dont chacun des angles est tronqué perpendiculairement à la diagonale y aboutissant et à une même distance du centre, les troncatures desdits carrés coïncidant et leurs centres formant les sommets d'un carré de côté égal au demi-pas (p) de la translation, l'un des quatre carrés tronqués constituant un site non conducteur (3), tandis que les trois autres comportent une métallisation munie d'une ouverture centrale (4) constituant également un site non conducteur, la distance desdites troncatures aux centres des carrés étant par ailleurs telle que lesdits carrés enferment un site carré non conducteur (2) dont les dimensions, de même que celles des ouvertures centrales (4), sont suffisantes pour que l'on puisse y réaliser un trou métallisé de connexion sans pour autant crér de liaison avec le réseau.

2. Ebauche pour circuit électrique multicouche comprenant un support plat en matériau isolant qui contient au moins une couche interne (5,6) parallèle aux faces du support et présentant un réseau conducteur continu formée par la répétition à deux dimensions d'un même motif, caractérisée en ce que la répétition s'effectue, par translation de pas (2 p) suivant deux directions orthogonales, d'un motif constitué de quatre carrés dont les diagonales sont parallèles aux dites directions orthogonales et dont chacun des angles est tronqué perpenJFo/ChD diculairement à la diagonale y aboutissant Le 4 février 1985 et à une même distance du centre, les centres des carrés formant les sommets d'un autre carré de côté égal au demi-pas (p) de la translation, l'un des quatre carrés du motif constituant un site non conducteur(3) tandis que les trois autres comportent une méallisation et deux carrés comportant une métallisation et se déduisant l'un de l'aitre par une translation d'amplitude (P) suivant l'une desdites directions orthogonales étant reliés par une zone métallisée en forme de bande parallèle à la direction de ladite translation la dimension des carrés du motif et la largeur des zones en forme de bandes étant, par ailleurs, telle que les dits carrés enferment un autre site carré non conducteur (2) dont les dimensions ,de même que celles du site non conducteur (3), sont suffisantes pour que l'on puisse y réaliser un trou métallisé de connexion sans pour autant créer de liaison avec le réseau.

3. Ebauche suivant la revendication 1 ou 2, caractérisée en ce qu'elle comporte deux couches intérieures (5,6) dont les grilles sont décalées de p suivant une des dimensions du réseau.

4. Ebauche suivant la revendication 2, caractérisée en ce que les deux couches internes constituent l'une liaison de masse, l'autre liaison d'alimentation.

5. Procédé de fabrication de circuits électriques multicouches double face à partir d'une ébauche suivant l'une quelconque des revendications 1 à 4, caractérisé en ce que l'on effectue les connexions entre les faces et une couche interne par perçage d'un trou en l'un des-1its autres sites et métallisation du trou.

6. Procédé suivant la revendication 5, caractérisé en ce que, ladite ébauche contenant deux couches internes décalées l'une par rapport à l'autre du pas p dans l'une des directions du réseau le trou est percé en un desdits autres sites de la couche à relier qui est superposé à un site non conducteur (3) de l'autre couche.

7. Procédé suivant la revendication 5 ou 6, caractérisé en ce que la jonction entre un composant porté par une face et un trou métallisé de connexion avec une couche est effectuée par une piste métallique formée entre un site de la première grille et un site de la seconde grille sur ladite face.

**Patentansprüche**

1.Elektrische Roh-Mehrschicht-Leiterplatte, umfassend einen flachen Träger aus isolierendem Material, welcher wenigstens eine interne, parallel zu den Hauptflächen des Trägers angeordnete Zwischenschicht (5, 6) enthält, die ein zusammenhängendes Leiternetz bildet, welches durch die Wiederholung eines gleichen Druckmusters in zwei Achsenrichtungen gebildet ist, dadurch gekennzeichnet, daß diese Wiederholung durch den versatz eines Druckmusters in zwei senkrecht zueinander stehenden Richtungen mit einer Schrittweite 2 p dargestellt wird, wobei das Druckmuster aus vier Vierecken besteht, deren Diagonalen zu den genannten, senkrecht zueinander stehenden Versatz-Richtungen parallel sind und deren Ecken jeweils senkrecht zu den zu diesen führenden Diagonalen in jeweils gleicher Entfernung vom Mittelpunkt abgeschnitten sind, wobei die Abschnittlinien dieser Vierecke zusammenfallen und ihre Mittelpunkte die Ecken eines Viereckes mit gleichen Seiten mit einer Seitenlänge entsprechend einer halben Versatz,Schrittweite p bilden, wobei eines der vier abgeschnittenen Vierecke eine nichtleitende Stelle (3) bildet, während die drei anderen Vierecke eine Metallisierung mit einer zentralen Ausnehmung (4) aufweisen, die ebenfalls eine nichtleitende Stelle bildet, wobei die Entfernung der Abschnittlinien zu den Mittelpunkten der Vierecke darüber hinaus derart ist, daß die Vierecke eine viereckige, nichtleitende Stelle (2) einschließen, deren Abmessungen ebenso wie die der zentralen Ausnehmungen (4) ausreichend sind, um dort eine metallisierte Durchkontaktierungs-Bohrung zu realisieren, ohne dabei eine Verbindung mit dem Leiternetz herzustellen,

2. Elektrische Roh-Mehrschicht-Leiterplatte mit einem flachen Träger aus isolierendem Material, welcher wenigstens eine interne, parallel zu den Hauptflächen des Trägers angeordnete Zwischenschncht (5, 6) enthält, die ein zusammenhängendes Leiternetz bildet, welches durch die Wiederholung eines gleichen Druckmusters in zwei Achsenrichtungen gebildet ist, dadurch gekennzeichnet, daß diese Wiederholung durch den Versatz eines Druckmusters in zwei senkrecht zueinander stehenden Richtungen mit einer Schrittweite 2 p dargestellt wird, wobei das Druckmuster aus vier Vierecken besteht, deren Diagonalen zu den genannten, senkrecht zueinander stehenden Versatz-Richtungen parallel sind und deren Ecken jeweils senkrecht zu den zu diesen Ecken führenden Diagonalen in jeweils gleicher Entfernung vom Mittelpunkt abgeschnitten sind, wobei die Mittelpunkte der Vierecke die Ecken eines ande ren Viereckes mit gleichen Seitenlängen entsprechend einer halben Versatz-Schrittweite p bilden, wobei eines der vier Vierecke des Druckmusters eine nichtleitende Stelle (3) bildet, während die drei anderen Vierecke eine Metallisierung aufweisen und wobei wiederum zwei der Vierecke jeweils eine Metallisierung aufweisen und eines sich vom anderen durch einen Versatz von der Größe p entlang einer der senkrecht zueinander stehenden Versatz-Richtungen ableitet und wobei die beiden Vierecke jeweils durch eine metallisierte, bandförmige Zone verbunden sind, die parallel zur Versatzrichtung ausgerichtet ist, und wobei die Abmessungen der Vierecke des Druckmusters und die Breite der bandförmigen Zonen derart sind, daß die genannten Vierecke eine andere viereckige, nichtleitende Stelle (2) ein-schließen, deren Abmessungen, ebenso wie die der nichtleitenden Stelle (3) ausreichend groß sind, um dort eine metallisierte Durchkontaktierungs-Bohrung zu realisieren, ohne dabei eine Verbindung mit dem Leiternetz herzustellen.

3. Leiterplatte nach einem der Ansprüche 1 und 2, dadurch gekennzeichnet, daß sie zwei interne Zwischenschichten (5, 6) enthält, deren Anordnungsgitter um eine Schrittweite p in einer Ausdehnungsrichtung des Leiternetzes versetzt sind,

4. Leiterplatte nach Anspruch 2, dadurch gekennzeichnet, daß von den beiden internen Zwischenschichten eine für ennen Masseanschluß, die andere für einen Versorgungsan-schluß ausgebildet ist,

5. Verfahren zur Herstellung von zweiseitigen elektrischen Mehrschicht-Leiterplatten aus einer Roh-Leiterplatte nach einem der Ansprüche 1 bis 4, dadurch gekennzeichnet, daß die Verbindung zwischen den Hauptflächen und einer internen Schicht durch Einbringen einer Bohrung an einer der genannten anderen Stellen (4) sowne Metallisierung dieser Bohrung hergestellt werden,

6. verfahren nach Anspruch 5, dadurch gekennzeichnet, daß bei einer zwei interne, gegeneinander um die Schrittweite p in einer Richtung des Leiternetzes versetzte Zwischenschichten enthaltende Roh-Leiterplatte die Bohrung in einer der genannten anderen Stellen (4) Mer zu verbindenden Schicht eingebracht wird, welche über einer nichtleitenden Stelle (3) der anderen Zwischenschicht angeordnet ist,

7. Verfahren nach einem der Ansprüche 5 oder 6, dadurch gekennzeichnet, daß die Verbindung zwischen einem auf einer Hauptfläche montierten Bauelement und einer metallisierten Bohrung zur Durchkontaktierung zu einer Zwischenschicht durch eine metallische Leiterbahn (9) hergestellt wird, die zwischen einem Knoten des ersten Anordnungsgitters und einem Knoten des zweiten Anordnungsgitters auf der genannten Hauptfläche verläuft.

**Claims**

1. A blank for a multi-layer electrical circuit board, comprising an electrically insulating flat substrate having at least one inner layer (5, 6) parallel to the faces of the substrate and having an electrically conductive network formed by the repetition of a predetermined elementary pattern in two directions, characterized in that said repetition occurs through rectilinear movement, with a pitch (2p) along two orthogonal directions, of a pattern consisting of four square areas whose diagonals are parallel to said orthogonal directions, the angles of each square area being truncated perpendicularly to the diagonal thereof and at a same distance from the center, the truncations of said square areas being in coincidence and their centers constituting the apices of a square having a side length equal to the half pitch (p) of the rectilinear movement, one of the four truncated square areas constituting a nonconducting site (3) without the three others have a plating formed with a central opening (4) also forming a non-conducting site, the distance between said truncations and the centers of the square areas being such that said square areas enclose a non-conducting square site (2) whose dimensions, as well as the dimensions of the central openings (4) are sufficient for rendering it possible to form a connection plated hole while creating a junction with the network.

2. A blank for a multi-layer electrical circuit board, comprising an electrically insulating flat substrate having at least one inner layer (5, 6) parallel to the faces of the substrate and having an electrically conductive network formed by the repetition of a predetermined elementary pattern in two directions, characterized in that said repetition occurs through reactilinear movement, with a pitch (2p) along two orthogonal directions, of a pattern consisting of four square areas whose diagonals are parallel to said orthogonal directions, the angles of each square area being truncated perpendicularly to the diagonal thereof and at a same distance from the center, the centers of the square areas being appices of an other square having a side dimensions equal to the half pitch (p) of the rectilinear movement, one of the four square areas of the pattern constituting a non-conducting site (3) while the three others have a plating, two square areas which have a plating and which are deducted from each other by a rectilinear movement of amplitude (p) along one of said orthogonal directions being connected by a metalplated zone elongated in a direction parallel to the direction of said rectilinear movement, the size of the square areas of the pattern and the width of the elongated zones being such that said square areas enclose an other non-conducting square site (2) whose dimensions, as well as the dimensions of the non-conducting site (3) are sufficient for rendering it possible to form a connection metal-plated hole without creating a junction with the network.

3. A blank according to claim 1 or 2, characterized in that it comprises two inner layers (5, 6) whose grids are off-set by p along one of the directions of the network.

4. A blank according to claim 2, characterized in that one of said inner layers constitutes a ground plane and the other one constitutes a power supply plane.

5. A process for manufacturing double face multi-layer electrical circuit boards from a blank according to any one of claims 1-4, characterized in that connections between the faces and an inner layer are made by drilling a hole at one of said other sites and plating the hole.

6. A process according to claim 5, characterized in that, said blank having two inner layers which are off-set with respect to each other by p along one of the directions of the network, the hole is drilled in one of said other sites of the layer to be connected which is above a non-conducting site (3) of the other layer.

7. A process according to claim 5 or 6, characterized in that the connection between a component carried by a face and a plated hole for connection with a layer is made by a metal path formed between a site of said first grid and a site of the second grid on said face.

# FIG.1

# FIG.2

FIG.3

# FIG.4